# EUROPÄISCHE PATENTSCHRIFT

(11) **EP 2 523 294 B1**
(45) Veröffentlichungstag und Bekanntmachung des Hinweises auf die Patenterteilung: **02.12.2020**
(21) Anmeldenummer: 12161505.8
(22) Anmeldetag: 27.03.2012
(51) Int. Cl.: H02H 9/02, H02M 1/088, H02M 3/158, H03K 17/12, H02H 3/00, H02J 1/10

(54) **Schaltungsanordnung für eine Schutzeinrichtung für elektrische Anlagen**
Switching assembly for a protection device for electrical assemblies
Circuit pour un dispositif de protection pour installations électriques

(30) Priorität: 05.04.2011 DE 102011006788
(43) Veröffentlichungstag der Anmeldung: 14.11.2012
(73) Patentinhaber: Atos Convergence Creators GmbH, 1210 Wien (AT)
(72) Erfinder: Fuchs, Alfred, 2410 Hainburg/Donau (AT); Butas, Jan, 922 21 Moravany nad Váhom (SK)
(74) Vertreter: Novagraaf Technologies

(56) Entgegenhaltungen:
- EP-A1- 2 053 741
- WO-A2-2005/015741
- DE-A1- 19 508 685
- US-A1- 2010 033 154

## Beschreibung

### Technisches Gebiet

Die Erfindung betrifft eine Schaltungsanordnung für eine Schutzeinrichtung für eine Anlage mit einer oder mehreren elektrischen Energiequellen zur Energieversorgung wie z.B. Satellitensysteme und/oder Satelliten-Testsysteme, wobei bei diesen Anlagen aufgrund der unterschiedlichen Energiequellen unterschiedliche Strom- und/oder Spannungsparametern auftreten können. Entsprechend der jeweils eingesetzten Energiequellen (z.B. Solarzellen, Batterie, etc.) können dann die Strom- und/oder Spannungsparameter stark variieren.

### Stand der Technik

Bei komplexen Anlagen, wie z.B. Satelliten und/oder Systeme zum Testen von Satelliten, werden meist von einer, meist aber mehreren unterschiedlichen, elektrische Energiequellen mit Energie bzw. Strom versorgt. Unter einer elektrischen Energiequelle wird üblicherweise eine Spannungs- oder eine Stromsquelle verstanden.
Als Spannungsquelle wird ein Gerät bezeichnet, welches im Idealfall eine von einem angeschlossenen Verbraucher - wie z.B. einer Anlage - unabhängige (konstante) elektrische Spannung bzw. einen vom Verbraucher abhängigen elektrischen Strom liefert. Spannungsquellen sind beispielsweise Batterien, Ackumulatoren, Generatoren, Netzgeräte, etc. Eine ideale Stromquelle liefert im Gegensatz zur idealen Spannungsquelle einen von einem Verbraucher unabhängigen - d.h. konstanten - elektrischen Strom. Im Gegensatz zur Spannungsquelle wird von der Stromquelle nicht mit einer festen elektrischen Spannung gearbeitet. Als Stromquelle können beispielsweise Solarzellen, welche auf Basis der Photovoltaik elektrische Energie erzeugen, betrachtet werden. Ideale elektrische Spannungs- und Stromquellen haben außerdem zueinander entgegengesetzte Eigenschaften.

Üblicherweise werden für bei der Energieversorgung von Verbrauchern, Geräten, Anlagen, etc. Spannungsquellen eingesetzt, wobei diese Spannungsquellen (z.B. Batterie, Netzgerät, "Steckdose", etc.) je nach Bauart bzw. nach den Prinzip der Energiegewinnung, -speicherung und/oder -transport, etc. sehr unterschiedlich Werte bei den elektrischen Parametern, insbesondere bei zur Verfügung gestellter Spannung und/oder Stromstärke aufweisen können. Aber auch Stromquellen wie z.B. Solarzellen können - je nach Schaltung der einzelnen Zellen - unterschiedliche elektrische Parameter besitzen.

Zusätzlich ist bei realen elektrischen Energiequellen - d.h. bei Spannungs- wie Stromquellen - zu berücksichtigen, dass durch den jeweiligen Verbraucher die Spannung bzw. der Strom absinkt bzw. durch sogenannte Anomalien (z.B. Störung im Verbraucher, Kurzschluss, Störung in der Energiequelle, etc.) Schwankungen der Werte für Spannung und/oder Stromstärke auftreten können. Diese Schwankungen können nicht nur Störungen, sondern auch Schäden am jeweiligen Verbraucher bzw. an der jeweiligen Anlage verursachen. Daher sind meist Schutzeinrichtungen (z.B. Sicherungen, Schalter, etc.) vorgesehen, von welchen bei Anomalien möglichst rasch eine Stromzufuhr unterbrochen wird.

Bei Satelliten beispielsweise werden unterschiedliche Energiequellen wie z.B. Solarzellen-Felder, Spezialbatterien, etc. zur Energie- bzw. Stromversorgung verwendet. Bei Testanlagen für Satelliten werden diese unterschiedlichen Energiequellen ebenfalls zumindest mittels entsprechender Simulatoren simuliert. Die Energieversorgung des Satelliten ist allerdings ein relativ heikler Teil, da jeder Defekt die Funktionsweise stark beeinträchtigen bzw. unmöglich machen kann. Bei der Testanlage können Defekte zu kostspieligen Schäden an der Testanlage und/oder am zu testenden Satelliten führen.

Deshalb werden z.B. zwischen den elektrischen Energiequellen und dem Satelliten bzw. beim Testfall zwischen den Simulatoren der Energiequellen und dem zu testenden Satelliten Schutz- bzw. Sicherheitseinrichtungen vorgesehen. Diese Schutzeinrichtungen haben die Aufgabe die Energie- bzw. Stromzufuhr im Falle einer Anomalie - beispielsweise bei einer Satellitenintegration oder bei Tests - möglichst schnell zu unterbrechen. Die Stromunterbrechung bzw. die Spannungsfreischaltung des Satelliten und/oder der Testanlage sollte dabei idealer Weise im Bereich von wenigen Millionstel Sekunden von der Schutzeinrichtung durchgeführt werden, um Schäden an der Anlage, am Satelliten, etc. zu verhindern.

Durch den Einsatz von verschiedenen elektrischen Energiequellen, insbesondere im Bereich der Satellitentechnik, wie z.B. Solarzellen-Felder, Spezialbatterien, etc. bzw. deren Simulatoren sind aufgrund der unterschiedlichen elektrischen Parameter (z.B. Spannung, Stromstärke, etc.) anwendungsspezifische Schutzeinrichtungen notwendig. So weisen z.B. die Kanäle eines Simulators für ein Solarzellen-Feld Spannungen von ca. 70 Volt und Stromstärken von ca. 3 Ampere auf, während ein Simulator für die Spezialbatterie einen Spannung von ca. 28 Volt und eine Stromstärke von ca. 150 Ampere besitzen kann.

Die Schutzeinrichtungen werden daher auf den jeweiligen Anwendungsfall wie z.B. auf die jeweilige Energiequelle oder deren Simulator angepasst. Üblicherweise bestehen derartige Schutzeinrichtungen aus einem anwendungsunabhängigen Steuerteil und einer anwendungsspezifischen - d.h. auf die jeweiligen elektrischen Parameter angepasste - Schaltvorrichtung. In dieser Schaltvorrichtung werden dann beispielsweise Messeinrichtungen für elektrische Parameter sowie Schalter (z.B. Thyristoren, Schütze, etc.) an die jeweiligen Gegebenheiten angepasst und müssen oft - vor allem bei hohen Stromstärken - speziell dafür entwickelt werden.

Damit führt die hohe Variabilität der elektrischen Parameter zu einer relativ großen Variantenvielfalt bei den Schutzeinrichtungen. Dadurch werden meist relativ hohe Kosten für diese Schutzeinrichtungen verursacht. Im nachteiligsten Fall muss für jeden Energiequellentyp eine spezifische Schutzeinrichtung bzw. Schaltvorrichtung vorgesehen werden, deren Bauteile (z.B. Messeinrichtung, Schalter, etc.) auf die elektrischen Parameter angepasst sind. Diese Schutzeinrichtung ist dann nicht mehr flexibel einsetzbar und es wird damit auch sehr aufwendig, beispielsweise in der Satellitentechnik einzelne Komponenten der Anlage unabhängig von den anderen zu testen.

Zusätzlich weisen diese speziellen Schutzeinrichtungen bzw. deren Schaltungsanordnungen den Nachteil auf, dass insbesondere Schutzeinrichtungen für hohe Ströme kostspielige Einzelanfertigungen sind und z.B. bei höheren Stromstärken längere Reaktionszeiten bei Sicherheitsabschaltungen aufweisen können. Dadurch kann es zusätzlich zu Schäden am Satelliten bzw. an Komponenten der Anlage kommen.

Aus der Schrift EP 0 664 613 A2 ist eine Vorrichtung zur Symmetrierung einer Belastung parallel geschalteter Leistungshalbleitermodule bekannt. Dabei werden durch Strommessungen bei den Leistungshalbleitermodulen entweder Ein- und Ausschaltzeitpunkte derart bestimmt, dass eine gleichmäßige Stromverteilung beim Schalten aller Module erzielt wird. Durch eine kontinuierliche Messung der Ströme in den Leistungshalbleitermodulen wird ein Regelungsverfahren erzielt, durch welches die Module nicht überlastet werden und in ihrem vorgesehen Leistungsbereich eingesetzt werden. Die in der Schrift EP 0 664 613 A2 weist allerdings den Nachteil auf, dass bei einem Einsatz von verschiedenen Energiequellen mit unterschiedlichen elektrischen Parametern keine rasche Reaktionszeit bzw. keine rasche Abschaltung möglich ist, durch die Strommessung in den Leistungsmodulen nur Ein- bzw. Ausschaltzeitpunkt iterativ bestimmt werden.

Die Schrift WO 2005/015741 A2 beschreibt eine elektronische Leistungsumrichtung und -steuerschaltung bestehend aus parallel geschalteten MOSFETs, deren Widerstandswerte gesteuert werden können, um den Strom entsprechend in den Zweigen aufzuteilen.

Die Schrift US 2010/0033154 A1 beschreibt einen Leistungsumrichter bestehend aus mehreren Kanälen mit einem jeweiligen "on-time"-Generator. Ein Addierer kombiniert die Ströme in den Kanälen zu einem Summenstrom. Ein Fehlerstromsignalgenerator detektiert die Unterschiede jeweils eines Kanalstromes und einem Zielwert.

### Darstellung der Erfindung

Der Erfindung liegt daher die Aufgabe zugrunde, eine Schaltungsanordnung für eine Schutzeinrichtung anzugeben, durch welche auf einfache und kostengünstige Weise Energiequellen mit unterschiedlichen elektrischen Parametern sicher und ohne Schäden für die Anlage geschalten werden können, und welche flexibel einsetzbar ist.

Erfindungsgemäß erfolgt die Lösung der Aufgabe durch eine Anordnung der eingangs erwähnten Art, bei der zumindest drei parallel geschaltete Sicherungskanäle vorgesehen sind. Diese Sicherungskanäle umfassen zumindest eine Strommesseinrichtung sowie zumindest einen Schalter zum Unterbrechen eines Stromflusses. Die Sicherungskanäle weisen auch definierte Widerstandswerte derart auf, dass ein Summenstrom symmetrisch zwischen den zumindest drei Sicherheitskanälen aufgeteilt wird. Zusätzlich besteht die erfindungsgemäße Schaltungsanordnung aus einer zentralen Steuerlogik zum Kontrollieren und Schalten der Sicherheitskanäle.

Der Hauptaspekt der erfindungsgemäß vorgeschlagenen Lösung besteht darin, dass durch einen Einsatz von zumindest drei oder idealer Weise mehreren parallel geschalteten Sicherheitskanälen ein Strom - z.B. zwischen zu testendem Satelliten und den jeweiligen Energiequellen oder deren Simulatoren - auf diese Sicherheitskanäle, welche bidirektional sind, aufgeteilt wird. Durch einen definierten Widerstandswert in den Sicherheitskanälen wird eine annähernd symmetrische Aufteilung erzielt, wodurch gängige Strommesseinrichtungen, Schalter, etc. eingesetzt werden können. Dadurch ist die erfindungsgemäße Schaltungsanordnung für eine Schutzeinrichtung nicht nur kostengünstig, sondern auch flexibel für verschiedene Energiequellen als Schutzeinrichtung anwendbar und kann rasch an die jeweilige Anwendung angepasst werden. Zusätzlich werden durch die erfindungsgemäße Schaltungsanordnung auch bei relativ großen Stromstärken - insbesondere durch die Aufteilung des Stroms - rasche Reaktionszeiten bei Sicherheitsabschaltungen erreicht und somit Schäden an Komponenten der zu sichernden Anlage (z.B. Satellit, Energiequellen, Simulatoren, etc.) vermieden.

Erfindungsgemäß ermittelt die zentrale Steuerlogik den Summenstrom der Sicherheitskanäle sowie Differenzen der Ströme in den Sicherheitskanälen. Auf diese Weise kann sehr einfach eine Aufteilung des Stroms auf die Sicherheitskanäle überwacht und für eine annähernd symmetrische Aufteilung gesorgt werden.

Erfindungsgemäß sind in der zentralen Steuerlogik Schwellwerte für Summenstrom und Differenzen der Ströme in den Sicherheitskanälen programmierbar. Durch einen Vergleich von gemessenen Summenstrom und Differenzen der Ströme in den Sicherheitskanälen mit in der zentralen Steuerlogik einprogrammierten Schwellwerten können die Sicherheitskanäle entsprechend geschaltet werden. Durch die damit erzielbaren Schaltzustände, insbesondere der Schalter in den jeweiligen Sicherheitskanälen, können auf einfache Weise Schwankungen z.B. des Stroms in den jeweiligen Sicherheitskanälen kompensiert werden.

Durch diese Kontrollmechanismen, insbesondere Messen von Summenstrom und Stromdifferenzen in den Sicherheitskanälen und Vergleich mit Schwellwerten, wird eine relativ hohe Fehlersicherheit der erfindungsgemäßen Schaltungsanordnung bzw. der Schutzeinrichtung erreicht. So kann beispielsweise ein Defekt in einem der Sicherheitskanäle erkannt und durch entsprechendes Schalten der anderen Sicherheitskanäle durch die zentrale Steuerlogik ausglichen werden, sodass dieser Defekt nicht zu einem Schaden an der Satelliten-Hardware führt.

Eine bevorzugte Ausführung der erfindungsgemäßen Schaltungsanordnung sieht vor, dass zusätzlich zu dem zumindest einen Schalter je Sicherheitskanal jeweils ein Sicherheitsrelais für eine elektrische Isolierung und/oder Sicherung vorgesehen ist. Durch einen zusätzlichen Einsatz von Sicherheitsrelais in jedem Sicherheitskanal wird auf einfache Weise eine weitere Absicherung der erfindungsgemäßen Schaltungsanordnung erreicht, wobei die Verwendung dieser Relais insbesondere durch die parallele Schaltung der Sicherheitskanäle und die daraus resultierende Aufteilung des Stroms ermöglicht wird. Dabei ist es wichtig, dass von den Sicherheitsrelais garantiert wird, dass ein rückgemeldeter Schaltzustand einem tatsächlichen Schaltzustand entspricht. Diese spezielle Eigenschaft wird durch die Bauart der Sicherheitsrelais erreicht.

Weiters empfiehlt sich, wenn als zentrale Steuerlogik eine parametrierbare und programmierbare logische Schaltung, insbesondere ein so genanntes Field Programmable Gate Array (FPGA) vorgesehen ist. Durch den Einsatz einer parametrierbaren und programmierbaren logischen Schaltung wie z.B. einem FPGA können auf einfache Weise Messwerte wie Summenstrom, Stromdifferenzen in den Sicherheitskanälen, etc. ausgewertet und/oder mit Schwellwerten verglichen werden, da dadurch in der zentralen Steuerlogik einfache arithmetische Operationen rasch und leicht implementierbar sind. Zusätzlich können dadurch die Kontroll-, Filter- und Schaltfunktionen der zentralen Steuerlogik sehr leicht erweitert, geändert oder an neue Anwendungen angepasst werden.

Ein Field Programmable Gate Array oder kurz FPGA ist ein so genannter integrierter Schaltkreis (IC) der Digitaltechnik, in dem logische Schaltungen programmiert werden können, wobei vor allem Strukturvorschriften für die Schaltung festgelegt werden. Damit werden zunächst eine grundlegende Funktionsweise einzelner Blöcke (z.B. der Sicherheitskanäle, etc.) der Schaltung vorgegeben und dann deren Verschaltung untereinander festgelegt. FPGA werden insbesondere in Bereichen eingesetzt, in welchen es auf eine schnelle Signalverarbeitung und eine flexible Änderung einer Schaltung ankommt. In der erfindungsgemäßen Schaltanordnung werden durch den Einsatz eines FPGAs daher auf einfache Weise rasche Reaktionszeiten und eine schnelle Anpassung der Sicherheitskanäle aufgrund von Messwerten in den Sicherheitskanälen erreicht.

Es ist vorteilhaft, wenn der zumindest eine Schalter je Sicherheitskanal als so genannter Feldeffekttransistor und die Strommesseinrichtung je Sicherheitskanal als Messwiderstand oder so genannter Shunt ausgestaltet ist. Ein Feldeffekttransistor oder kurz FET ist ein spannungsgesteuertes Schaltungselement, bei welchem über eine Spannung - der so genannten Gate-Source-Spannung - bzw. ein Signal aus einer Steuerlogik ein Halbleiterwiderstand reguliert werden kann, um so eine Stärke des elektrischen Stroms in einem Schaltungszweig wie z.B. einem Sicherheitskanal zu schalten und/oder zu steuern. Durch den Einsatz von FETs als Schalter in den Sicherheitskanälen kann daher auf sehr einfache und effiziente Weise der Widerstandswert eines Sicherheitskanals der erfindungsgemäßen Schaltungsanordnung von der zentralen Steuerlogik gesteuert werden. Auf diese Weise werden auch Schwankungen in Widerstand eines Sicherheitskanals kompensiert.

Für die Messung der Stromwerte in den Sicherheitskanälen werden Messwiderstände oder so genannte Shunts eingesetzt. Ein Shunt ist ein so genannter Nebenschlusswiderstand, welcher meist einen niederohmigen elektrischen Widerstand aufweist und bei dem ein durch den fließenden Strom verursachter Spannungsabfall zur Messung dieses Stromes herangezogen wird. Da es Shunts für verschiedene Stromstärken und in verschiedenen Bauformen - z.B. auch zum Einlöten für so genannte gedruckte Schaltungen - gibt, sind Shunts flexibel einsetzbar und stellen damit auch eine sehr kostengünstige und genaue Methode für eine Strommessung in den Sicherheitskanälen der erfindungsgemäßen Schaltungsanordnung dar.

Bei Verwendung eines FPGAs als zentrale Steuerlogik sind zur Ansteuerung der FETs und zum Auswerten der Shunts in den Sicherheitskanälen üblicherweise noch so genannte Analog-/Digital-Konverter zwischen FET und Shunt sowie FPGA geschaltet.

Zweckmäßiger Weise sind die zumindest drei Sicherheitskanäle bzw. die Bauteile und Leitungen, welche die Sicherheitskanäle bilden, auf einer Leiterplatte implementiert. Durch eine Implementierung der Sicherheitskanäle auf derselben Leiterplatte wird einen gute Symmetrisierung der Stromaufteilung und zusätzlich auch eine Verteilung einer eventuell auftretenden Wärmeentwicklung über die Leiterplatte erreicht.

### Kurzbeschreibung der Zeichnung

Die Erfindung wird nachfolgend in beispielhafter Weise anhand der beigefügten Figuren erläutert. Es zeigen:
Figur 1 beispielhaft einen schematischen Aufbau der erfindungsgemäßen Schaltungsanordnung für einen Schutzeinrichtung auf einer Leiterplatte anhand eines Einsatzes bei eines Schutzgeräts für Satellitentechnik
Figur 2 beispielhaft und schematisch den Aufbau und Schaltung der Sicherheitskanäle und die Anbindung an die zentrale Steuerlogik von der erfindungsgemäßen Schaltungsanordnung

### Ausführung der Erfindung

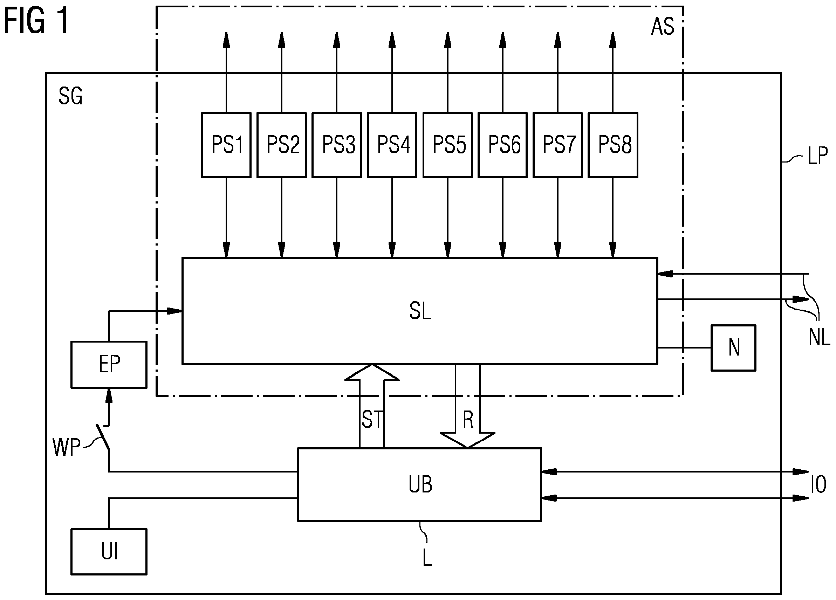

Figur 1 zeigt beispielhaft und in schematischer Weise ein Schutzgerät SG für ein Satelliten-Testsystem, wobei dieses Schutzgerät SG beispielhaft eine erfindungsgemäße Schaltungsanordnung AS für eine Schutzeinrichtung für eine Anlage, insbesondere für Satelliten bzw. Satelliten-Testsysteme umfasst.

Bei einem Satelliten werden verschiedene Energiequellen EQ für die Stromversorgung eingesetzt. Insbesondere sind das Solarzellen auf den Satelliten-Flügeln und eine Spezialbatterie. Vor einer Installation eines Satelliten in einer Umlaufbahn wird jede Komponente des Satelliten getestet. Dazu werden für einen Test der Energieversorgung Simulatoren eingesetzt, welche einerseits die On-Board-Spezialbatterie des Satelliten und andererseits die Solarzellen-Felder simulieren, um den Satelliten entsprechend zu testen. Um die einzelnen Komponenten des Satelliten sowie die Testsysteme vor Anomalien bei der Strom-/Spannungszufuhr zu schützen wird das in Fig. 1 schematisch und beispielhafte Schutzgerät SG in den Komponenten des Testsystems eingesetzt. Das Schutzgerät SG wie die erfindungsgemäße Schaltungsanordnung AS kann aber beispielsweise auch bei bereits installierten Satelliten sowie anderen Anlagen wie z.B. komplexen Industrieanlagen mit mehreren Energieversorgungsquellen verwendet werden.

Das Schutzgerät SG bzw. seine Komponenten sind dabei auf einer Leiterplatte LP untergebracht. Das Schutzgerät SG umfasst dabei eine Überwachungslogik UB, welche z.B. Schnittstellen L, IO zur Kommunikation mit anderen Komponenten des Satelliten-Testsystems wie z.B. einer zentralen Kontrolleinheit aufweist. Die Überwachungslogik UB kann als programmierbare logische Schaltung, beispielsweise als so genannter Field Programmable Gate Array (FPGA), ausgeführt sein. Die Schnittstelle L ist dabei beispielsweise eine Anbindung an ein so genanntes Local Area Network (LAN) und die Schnittstellen IO sind so genannte Ein-/Ausgabe-Schnittstellen IO, von welche z.B. die eine als digitale Ein-/Ausgabe-Schnittstelle und die andere als analoge Ein-/Ausgabe-Schnittstelle ausgeführt sein kann.

Weiters umfasst das Schutzgerät SG noch eine Benutzerschnittstelle UI, welche für eine direkte Kommunikation und gegebenenfalls zum Programmieren der Überwachungslogik UB eingesetzt werden kann. Zusätzlich weist das Schutzgerät SG noch einen programmierbaren, elektronischen Speicher EP auf, in welchen Parameter und/oder Daten für eine Parametrierung der erfindungsgemäßen Schaltungsanordnung AS abgelegt werden können. Der elektronische Speicher EP kann beispielsweise als so genanntes EEPROM - Electrically Erasable Programmable Readonly Memory - ausgestaltet sein. Dieser elektronische Speicher EP kann über die Überwachungslogik UB mit Daten beschrieben bzw. gelöscht werden, wobei als Löschschutz eine Schalter WP zwischen Speicher EP und der Überwachungslogik UB vorgesehen ist.

Die erfindungsgemäße Schaltungsanordnung AS besteht aus einer zentralen Steuerlogik SL, wobei als zentrale Steuerlogik SL ebenfalls eine parametrierbare und programmierbare logische Schaltung wie z.B. ein FPGA verwendet werden kann. Zum Auslesen der Parameter wie z.B. der Schwellwerte für Summenstrom und Differenzen von Strömen in den Sicherheitskanälen PS1, ..., PS8 weist die zentrale Steuerlogik SL eine Verbindung zum elektronischen Speicher EP auf. Zusätzlich ist an die zentrale Steuerlogik eine Vorrichtung N zur Notausschaltung angebunden, über welche das Schutzgerät gegebenenfalls zu einer Notabschaltung veranlasst werden kann. Über die Leitungen NL können dann Informationen über erfolgte Notausschaltungen an andere Komponenten (z.B. andere Schutzgeräte in der Anlage, etc.) versendet bzw. von anderen Komponenten (z.B. andere Schutzgeräte in der Anlage, etc.) empfangen werden.

An die zentrale Steuerlogik SL sind beispielhafte acht Sicherheitskanäle PS1, ..., PS8 parallel angebunden, in welchen sich aufgrund definierter Widerstandswerte ein Strom einer Energiequelle EQ annähernd symmetrisch aufteilt, und welche von der zentralen Steuerlogik SL kontrolliert und geschaltet werden. Die erfindungsgemäße Schaltungsanordnung AS kann natürlich je nach Bedarf auch weniger (zumindestdrei) oder auch mehr Sicherheitskanäle PS1, ..., PS8 aufweisen. Für eine Kontrolle bzw. Schalten der Sicherheitskanäle PS1, ..., PS8 werden von der zentralen Steuerlogik SL die Parameter (z.B. Schwellwerte, etc.) aus dem elektronischen Speicher EP herangezogen und Summenstrom der Sicherheitskanäle PS1, ..., PS8 und Differenzen der Ströme in den Sicherheitskanälen PS1, ..., PS8 berechnet. Entsprechend dieser Werte können dann die Sicherheitskanäle PS1, ..., PS8 geschaltet werden. Dazu - insbesondere für Kontrolle und Schalten der Sicherheitskanälen PS1, ..., PS8 wird die zentrale Steuerlogik SL über eine Anregung ST der Überwachungslogik UB getriggert. Entsprechende Ergebnisse werden dann als Antwort R von der zentralen Steuerlogik SL an die Überwachungslogik UB zurückgemeldet.

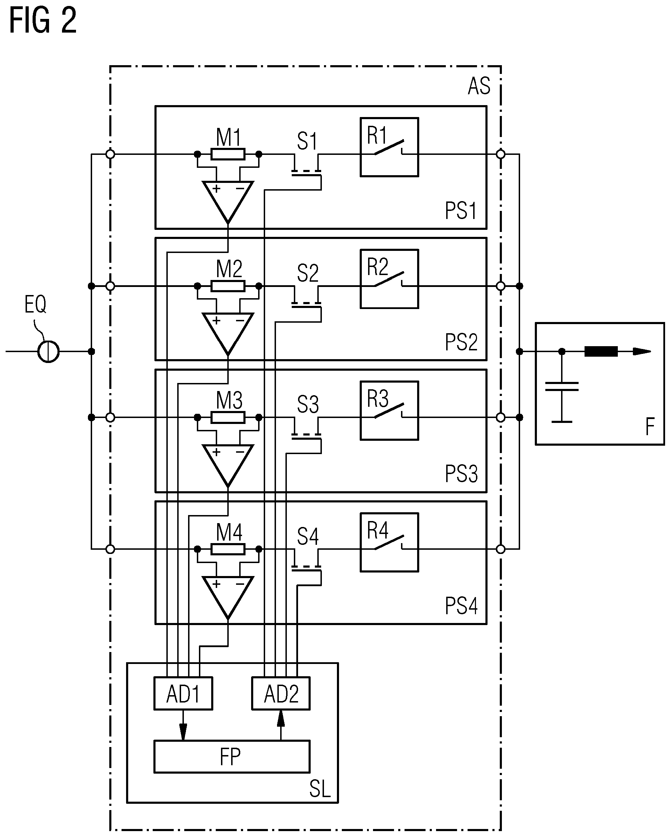

Figur 2 zeigt schematisch und vereinfacht einen detaillierten Aufbau der erfindungsgemäßen Schaltungsanordnung AS, wobei der Einfachheit halber und wegen des gleichen Aufbaus nur vier Sicherheitskanäle PS1 bis PS4 von den acht Sicherheitskanälen PS1, ..., PS8 aus Figur 1 dargestellt sind. Die erfindungsgemäße Schaltungsanordnung AS für eine Schutzeinrichtung weist wieder die zentrale Steuerlogik SL auf.

Die zentrale Steuerlogik besteht aus einer parametrierbaren und programmierbaren logischen Schaltung FP wie z.B. ein FPGA und zwei Konvertern AD1, AD2, welche als Analog-/Digital-Konverter ausgeführt sind. Die Konverter AD1 und AD2 haben die Aufgabe, einerseits die analogen Signale aus den Sicherheitskanälen PS1 bis PS4 in digitale und damit auswertbare Signale für die parametrierbare und programmierbare logische Schaltung FP umzuwandeln, andererseits aus den digitalen Signale der logischen Schaltung FP analoge Steuersignale für die Sicherheitskanäle PS1 bis PS4 zu generieren.

An die zentrale Steuerlogik sind über die Konverter AD1 und AD2 die parallel geschalteten Sicherheitskanäle PS1 bis PS4 angebunden. Ein Sicherheitskanal PS1, ..., PS4 umfasst dabei ein Strommessgerät M1, ..., M4 sowie einen Schalter S1, ..., S4. Zusätzlich ist in jedem Sicherheitskanal PS1 bis PS4 noch ein Sicherheitsrelais R1, ..., R4 vorgesehen, um für elektrische Isolierung und/oder Sicherung zusorgen. Die Sicherheitskanäle PS1 bis PS4 sind dabei so gestaltet, dass ein Strom aus der symbolisch dargestellten Energiequelle EQ annähernd symmetrisch auf die Sicherheitskanäle aufgeteilt wird. Am Ausgang werden die Sicherheitskanäle PS1 bis PS4 wieder zusammengefasst und über ein Filter F kann dann z.B. ein Gerät, eine Komponente einer Anlage, ein zu testendes Satelliten-System, etc. angeschlossen sein.

Als Strommessgeräte M1, ..., M4 werden beispielsweise so genannte Shunts oder Messwiderstände eingesetzt, welche aus einem Widerstand und einem Operationsverstärker für die Messung bestehen. Vom Strom, welcher durch den Widerstand fließt, wird dabei ein Spannungsabfall am Widerstand erzeugt, welche mit Hilfe des Operationsverstärkers gemessen wird, und der als Messwert für den Strom im jeweiligen Sicherheitskanal PS1, ..., PS4 dient. Dieser analoge Messwert wird vom jeweiligen Operationsverstärker an den ersten Konverter AD1 übermittelt, welcher den Messwert in einen digitalen Wert für die Auswertung durch die logische Schaltung FP umwandelt.

Als Schalter S1, ..., S4 werden in den Sicherheitskanälen PS1, ..., PS4 beispielsweise sogenannte Feldeffekttransistoren oder kurz FETs, insbesondere so genannte MOS-FETs eingesetzt. Mit den Feldeffekttransistoren S1, ..., S4 können die Sicherheitskanäle PS1, ..., PS4 nicht nur geschalten werden, sondern die Feldeffekttransistoren S1, ..., S4 können auch als kontrollierte Widerstände verwendet werden, um Schwankungen des definierten Widerstandswertes in einem Sicherheitskanal PS1, ..., PS4 zu kompensieren. Die Ansteuerung der Feldeffekttransistoren S1, ..., S4 erfolgt dabei durch die logische Schaltung FP der zentralen Steuerlogik SL. Dabei wird das digitale Steuersignal der logischen Schaltung FP vom zweiten Konverter AD2 in ein analoges Signal für die Feldeffekttransistoren S1, ..., S4 umgewandelt.

Wann bzw. welcher Feldeffekttransistor S1, ..., S4 gegebenenfalls gesteuert werden muss, wird von der logischen Schaltung FP der zentralen Steuerlogik SL durch Berechnung von Summenstrom und der Differenzen der Ströme in den Sicherheitskanäle PS1, ..., PS4 erkannt. Die ermittelten Stromwerte können dann in der logischen Schaltung FP der zentralen Steuerung SL noch mit vorgegebenen Schwellwerten verglichen werden und dann die Sicherheitskanäle PS1 bis PS4 entsprechend geschalten werden.

Zur elektrischen Sicherung bzw. Isolierung sind in den Sicherheitskanälen PS1 bis PS4 noch zusätzlich die Sicherheitsrelais R1 bis R4 eingebaut. Diese Sicherheitsrelais R1 bis R4 haben insbesondere die Eigenschaft, dass durch ihre Bauart garantiert wird, dass der gemeldete Schaltzustand auch dem tatsächlichen Schaltzustand entspricht.

An die Sicherheitskanäle PS1 bis PS4 bzw. PS1 bis PS8 der erfindungsgemäßen Schaltungsanordnung können dann z.B. die beliebig zu testende Komponenten des Satelliten und/oder Simulatoren des Testsystems angebunden werden, wobei dafür alle oder auch nur einige Sicherheitskanäle PS1 bis PS8 genutzt werden können - d.h. es kann beispielsweise ein Komponente an die Sicherheitskanäle PS1 bis PS3 angebunden sein und eine weitere Komponente die Sicherheitskanäle PS4 bis PS8 nutzen. Damit ist die erfindungsgemäße Schaltungsanordnung AS vielfältig und flexibel einsetzbar. Durch den Einsatz der parametrierbaren und programmierbaren logischen Schaltung FP in der zentralen Steuerlogik kann die erfindungsgemäße Schaltungsanordnung AS bzw. eine darauf basierende Schutzeinrichtung für verschiedenen Systeme eingesetzt und sehr rasch an spezifische Anforderungen von Systemen angepasst werden.

## Patentansprüche

1. Schaltungsanordnung (AS) für eine Schutzeinrichtung für eine Anlage, insbesondere für Satelliten und/oder Satelliten-Testsysteme, mit einer oder mehreren elektrischen Energiequellen (EQ), welche variable Strom- und/oder Spannungsparameter aufweisen, bestehend aus:
- zumindest drei parallel geschaltete Sicherungskanäle (PS1, ..., PS4), welche zumindest jeweils eine Strommesseinrichtung (M1, ..., M4 und zumindest einen Schalter (S1, ..., S4) umfassen, und welche derart definierte Widerstandswerte aufweisen, dass ein Summenstrom symmetrisch zwischen den Sicherheitskanälen (PS1, ..., PS4) aufgeteilt wird,
- und eine zentrale Steuerlogik (SL) zum Kontrollieren und Schalten der Sicherungskanäle (PS1, ..., PS4), von welcher ein Summenstrom der Sicherheitskanäle (PS1, ..., PS4) ermittelbar ist,
charakterisiert dadurch, dass von der zentralen Steuerlogik (SL) desweiteren Differenzen der Ströme in den Sicherheitskanälen (PS1, ..., PS4) ermittelbar sind, und wobei auf Basis eines Vergleichs von ermittelten Summenstrom und Differenzen der Ströme in den Sicherheitskanälen (PS1, ..., PS4) mit in der zentralen Steuerlogik (SL) einprogrammierten Schwellwerten die definierten Widerstandswerte der Sicherheitskanäle (PS1, ..., PS4) über die zentrale Steuerlogik (SL) derart ansteuerbar sind, dass Schwankungen der Widerstandswerte kompensiert werden.

2. Schaltungsanordnung nach Anspruch 1, **dadurch gekennzeichnet, dass** zusätzlich zu dem zumindest einen Schalter (S1, ..., S4) je Sicherheitskanal (PS1, ..., PS4) jeweils ein Sicherheitsrelais (R1, ...,R4) für eine elektrische Isolierung und/oder Sicherung vorgesehen ist.

3. Schaltungsanordnung nach einem der Ansprüche 1 bis 2, **dadurch gekennzeichnet, dass** als zentrale Steuerlogik (SL) eine parametrierbare und programmierbare logische Schaltung (FP), insbesondere ein so genannter Field Programmable Gate Array, eingesetzt ist.

4. Schaltungsanordnung nach einem der Ansprüche 1 bis 3, **dadurch gekennzeichnet, dass** der jeweils zumindest eine Schalter (S1, ..., S4) in den Sicherungskanälen (PS1, ..., PS4) als sogenannter Feldeffekttransistor ausgestaltet ist.

5. Schaltungsanordnung nach einem der Ansprüche 1 bis 4, **dadurch gekennzeichnet, dass** die Strommesseinrichtung (M1, ..., M4) in den Sicherheitskanälen (PS1, ..., PS4) als Messwiderstand oder so genannter Shunt ausgeführt ist.

6. Schaltungsanordnung nach einem der Ansprüche 1 bis 5, **dadurch gekennzeichnet, dass** die zumindest drei Sicherheitskanäle (PS1, ..., PS4) sowie die zentrale Steuerlogik (SL) gemeinsam auf einer Leiterplatte (LP) implementiert sind.

## Claims

1. Circuit arrangement (AS) for a protective device for an installation, in particular for satellites and/or satellite-testing systems, with one or more electrical power sources (EQ), which have variable current and/or voltage parameters, consisting of:
- at least three parallel connected safety channels (PS1, ..., PS4), which comprise respectively a current measuring device (M1, ..., M4) and at least one switch (S1, ..., S4), and which have defined resistance values such that a total current is divided symmetrically between the safety channels (PS1, ..., PS4),
- and a central control logic (SL) for controlling and switching the safety channels (PS1, ..., PS4), from which a total current of the safety channels (PS1, ..., PS4) can be determined,
**characterised in that** differences in the currents in the safety channels (PS1, ..., PS4) can also be determined by means of the central control logic (SL), and wherein on the basis of a comparison of determined current flow and differences in the currents in the safety channels (PS1, ..., PS4) with thresholds programmed into the central control logic (SL) the defined resistance values of the safety channels (PS1, ..., PS4) can be controlled by the central control logic (SL) such that fluctuations in the resistance values are compensated.

2. Circuit arrangement according to claim 1, **characterised in that** in addition to the at least one switch (S1, ..., S4) for each safety channel (PS1, ..., PS4) respectively a safety relay (R1, ..., R4) is provided for an electric insulation and/or protection.

3. Circuit arrangement according to any of claims 1 to 2, **characterised in that** as a central control logic (SL) a parameterisable and programmable logical circuit (FP), in particular a so-called Field Programmable Gate Array, is used.

4. Circuit arrangement according to any of claims 1 to 3, **characterised in that** the respective at least one switch (S1, ..., S4) in the safety channels (PS1, ..., PS4) is configured as a so-called field-effect transistor.

5. Circuit arrangement according to any of claims 1 to 4, **characterised in that** the current measuring device (M1, ..., M4) in the safety channels (PS1, ..., PS4) is designed as a measuring resistor or so-called shunt.

6. Circuit arrangement according to any of claims 1 to 5, **characterised in that** the at least three safety channels (PS1, ..., PS4) and the central control logic (SL) are implemented jointly on a circuit board (LP).

## Revendications

1. Ensemble formant circuit (AS) pour un dispositif de protection pour une installation, en particulier pour des satellites et/ou des systèmes de test de satellites, avec une ou plusieurs sources d'énergie (EQ) électriques, lesquelles présentent des paramètres de courant et/ou de tension variables, constitué :
- d'au moins trois canaux de sécurité (PS1, ..., PS4) branchés en parallèle, lesquels comprennent au moins respectivement un dispositif de mesure de courant (M1, ..., M4) et au moins un commutateur (S1, ..., S4), et lesquels présentent des valeurs de résistance définies de telle manière qu'un courant cumulé est réparti de manière symétrique entre les canaux de sécurité (PS1, ..., PS4),
- et d'une logique de commande (SL) centrale pour contrôler et commuter les canaux de sécurité (PS1, ..., PS4), par laquelle un courant cumulé des canaux de sécurité (PS1, ..., PS4) peut être déterminé,
**caractérisé en ce que** par ailleurs des différences des courants dans les canaux de sécurité (PS1, ..., PS4) peuvent être déterminées par la logique de commande (SL) centrale, et
dans lequel, sur la base d'une comparaison du courant cumulé et des différences des courants déterminés dans les canaux de sécurité (PS1, ..., PS4) aux valeurs de seuil programmées dans la logique de commande (SL) centrale, les valeurs de résistance définies des canaux de sécurité (PS1, ..., PS4) peuvent être pilotées par l'intermédiaire de la logique de commande (SL) centrale de telle manière que des fluctuations des valeurs de résistance sont compensées.

2. Ensemble formant circuit selon la revendication 1,
**caractérisé en ce qu'**est prévu, en plus de l'au moins un commutateur (S1, ..., S4) par canal de sécurité (PS1, ..., PS4) respectivement un relais de sécurité (R1, ..., R4) pour une isolation et/ou une sécurité électriques.

3. Ensemble formant circuit selon l'une quelconque des revendications 1 à 2,
**caractérisé en ce qu'**est utilisé en tant que logique de commande (SL) centrale un circuit (FP) logique paramétrable et programmable, en particulier ce qu'on appelle un FPGA [Field Programmable Gate Array ou réseau de portes programmables in situ].

4. Ensemble formant circuit selon l'une quelconque des revendications 1 à 3,
**caractérisé en ce que** l'au moins un commutateur (S1, ..., S4) respectif est configuré en tant que ce qu'on appelle un transistor à effet de champ dans les canaux de sécurité (PS1, ..., PS4).

5. Ensemble formant circuit selon l'une quelconque des revendications 1 à 4,
**caractérisé en ce que** le dispositif de mesure de courant (M1, ..., M4) est réalisé dans les canaux de sécurité (PS1, ..., PS4) en tant que résistance de mesure ou ce qu'on appelle shunt.

6. Ensemble formant circuit selon l'une quelconque des revendications 1 à 5,
**caractérisé en ce que** les au moins trois canaux de sécurité (PS1, ..., PS4) ainsi que la logique de commande (SL) centrale sont implémentés conjointement sur une carte de circuits imprimés (LP).
